# EUROPÄISCHE PATENTANMELDUNG

(11) **EP 0 908 974 A2**
(43) Veröffentlichungstag der Anmeldung: **14.04.1999**
(21) Anmeldenummer: 98116466.8
(22) Anmeldetag: 01.09.1998
(51) Int. Cl.: H01R 13/73, H05K 5/00

(54) **Baugruppe zum Einbau in ein Gehäuse und Einbauverfahren**

(30) Priorität: 06.10.1997 DE 19744093
(71) Anmelder: SIEMENS AKTIENGESELLSCHAFT, 80333 München (DE)
(72) Erfinder: Fritzsche, Christian, 93047 Regensburg (DE)

(57) **Zusammenfassung**

Eine Baugruppe (1) zum Einbau in ein Gehäuse (2) mit einem Steckverbinder (12), der quer zur Einbaurichtung der Baugruppe (1) angeordnet ist, weist ein Basisteil (11), eine auf dem Basisteil angeordnete Führung (111) für den Steckverbinder (12) und eine flexible elektrische Verbindung zwischen dem Steckverbinder (12) und dem Basisteil (11) auf. Nach dem Einbau der Baugruppe (1) in das Gehäuse (2) wird der Steckverbinder (12) von einem Greifwerkzeug eines Automaten durch ein Öffnung (21) gezogen.

## Beschreibung

Die Erfindung betrifft eine Baugruppe zum Einbau in ein Gehäuse mit einem Steckverbinder, der quer zur Einbaurichtung der Baugruppe angeordnet ist, sowie ein System aus der Baugruppe und einem Gehäuse und ein Verfahren zum Einbau einer Baugruppe in ein Gehäuse. Eine derartige Baugruppe kann beispielsweise das Trageteil eines vollständig in ein Getriebegehäuse eines Kraftfahrzeugs zu integrierenden Steuergeräts sein.

Beim Einbau eines Getriebesteuergeräts in ein Getriebegehäuse ist insbesondere bei Kraftfahrzeugen mit Hinterradantrieb ein Getriebestecker quer zur Einbaurichtung des Steuergeräts auszurichten. Dieser Stecker muß in einem rechten Winkel zu derjenigen Richtung, in der das Steuergerät in das Getriebegehäuse hineingeschoben wird, durch eine Öffnung des Getriebegehäuses nach außen ragen. Der Stecker muß zuverlässig gegen die Öffnung abgedichtet sein, damit kein Getriebeöl austreten kann.

Beim Einschieben des Getriebesteuergeräts muß sich der mit dem Steuergerät über flexible Leitungen verbundene Stecker innerhalb des Gehäuses befinden, wohingegen der Stecker im Betriebszustand durch das Gehäuse nach außen ragen muß. Um den Stecker nach dem Einbau des Getriebesteuergeräts durch die Öffnung im Getriebegehäuse ziehen zu können, kann eine sogenannte Fädelhilfe benutzt werden. Die Fädelhilfe weist ein Fixierstück zum Befestigen des Steckers und ein am Fixierstück befestigtes Band auf. Der Durchmesser der Fädelhilfe ist kleiner als der Durchmesser des Steckers. Eine Arbeitskraft steckt das Fixierstück der Fädelhilfe in den Stecker und fädelt das Band der Fädelhilfe durch die Öffnung.

Wenn das Getriebesteuergerät in das Getriebegehäuse geschoben wird, zieht die Arbeitskraft mit der Fädelhilfe den Stecker in die Öffnung des Getriebegehäuses. Anschließend kann der Stecker am Getriebegehäuse befestigt werden. Dieser Vorgang muß manuell durchgeführt werden und läßt sich nicht automatisieren.

Es ist bekannt, den Stecker für das Getriebesteuergerät zweiteilig auszubilden. Ein Teil des Steckers befindet sich zusammen mit dem Getriebesteuergerät innerhalb des Getriebegehauses. Ein zweiter Teil des Steckers wird von außen durch die Öffnung des Getriebegehäuses eingeführt und mit dem ersten Teil des Getriebesteckers verbunden. Es ist aber ein hoher Aufwand erforderlich, um den zweiteiligen Stecker und die Öffnung im Gehäuse abzudichten. Insbesondere sind viele Einzelteile, wie Befestigungselemente und Dichtringe erforderlich.

Aus der Patentschrift DE 196 06 481 C1 und der Offenlegungsschrift DE 195 29 665 A1 sind Getriebesteuerungen für den Einbau in ein Getriebegehäuse mit ortsfesten Steckverbindern bekannt.

Aus der Offenlegungsschrift DE 196 07 057 A1 ist eine elektrische Steckereinrichtung mit einem Steckerkörper bekannt, der in verschiedenen Stellungen auf einer Haltevorrichtung aufsteckbar ist. In der gesteckten Stellung kann der Steckerkörper bei der Montage nicht mehr versetzt werden.

Es ist ein Ziel der Erfindung eine Baugruppe mit einem Steckverbinder, der quer zur Einbaurichtung der Baugruppe ausgerichtet ist, zum Einbau in ein Gehäuse und ein Verfahren bereitzustellen, die einen einfachen und automatisierbaren Arbeitsablauf beim Einbau der Baugruppe in das Gehäuse ermöglichen.

Dieses Ziel wird mit einer Baugruppe, einem System und einem Verfahren erreicht, wie sie in den unabhängigen Patentansprüchen definiert sind. Vorteilhafte Ausführungsformen sind in den Unteransprüchen angegeben.

Da der Steckverbinder in einer Führung des Basisteils in einer definierten Position gehalten ist, kann von außen das Werkzeug eines Automaten durch die Öffnung des Gehäuses geführt und in Eingriff mit dem Steckverbinder gebracht werden. Anschließend kann der Automat den Steckverbinder in die Öffnung des Gehäuses ziehen und dort befestigen.

Der Steckverbinder kann ein Stecker oder eine Buchse sein.

Weitere Vorteile, Merkmale und Anwendungsmöglichkeiten ergeben sich aus der nachfolgenden Beschreibung eines Ausführungsbeispiels in Verbindung mit den Zeichnungen. Es zeigen:
- Figur 1: eine Hinteransicht einer Baugruppe,
- Figur 2: einen Schnitt durch die Ebene A-A von Figur 1 und durch ein Gehäuse mit dem Steckverbinder in Montageposition,
- Figur 3: eine perspektivische Darstellung der Baugruppe von Figur 2 in Montagestellung,
- Figur 4: die Baugruppe von Figur 2 in der Endposition, und
- Figur 5: die Baugruppe von Figur 4 in perspektivischer Darstellung.

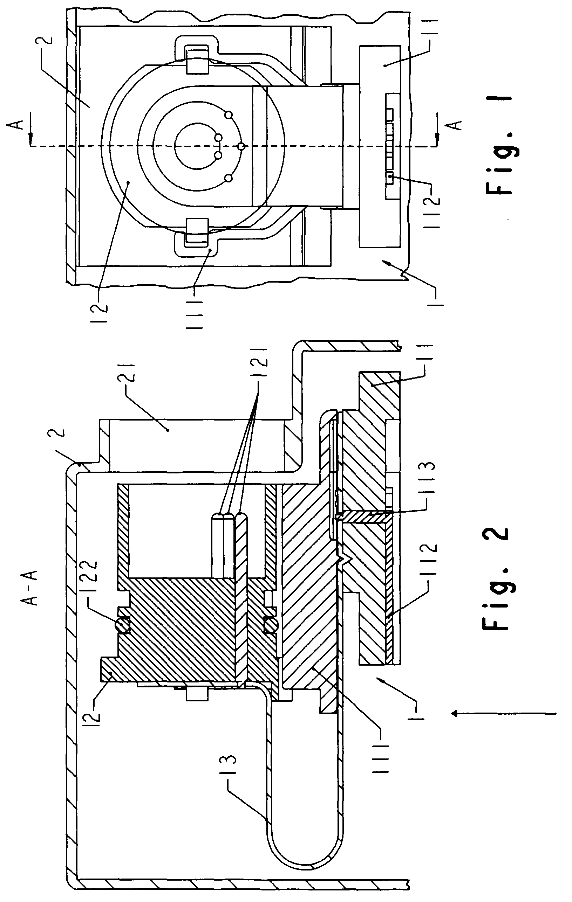

In Figur 1 ist eine Baugruppe 1 mit einem Basisteil 11 aus Kunststoff und einer auf das Basisteil geklipsten schienenartigen Führung 111 aus Kunststoff dargestellt. Die Baugruppe 1 ist ein mit einer elektronischen Getriebesteuerung (nicht dargestellt), einem Steckverbinder 12 und Aktuatoren (nicht dargestellt) versehene Trägerkörper.

In der Führung 111 ist der Steckverbinder 12 angeordnet. Sowohl die Führung 111 als auch der Steckverbinder 12 sind quer zur Einbaurichtung der Baugruppe angeordnet. Stanzgitter 112 im Basisteil 11 stellen eine elektrische Verbindung zu einer nicht dargestellten Steuerelektronik oder einer Energiequelle her. Die Steuerelektronik steuert ein Automatikgetriebe eines Kraftfahrzeugs.

Figur 2 veranschaulicht den Aufbau der Baugruppe 1 und ihre Positionierung in einem Gehäuse 2 mit einer Öffnung 21 für den Steckverbinder 12. Das Gehäuse 2 ist das Gehäuse eines Automatikgetriebes, in das die Baugruppe 1 gerade eingesetzt wird. Die Einbaurichtung der Baugruppe 1 wird durch den Pfeil veranschaulicht.

Der Steckverbinder 12 befindet sich in einer zurückgezogenen Montageposition, so daß die Baugruppe 1 von unten senkrecht nach oben in eine Öffnung des Gehäuses 2 eingeführt werden kann. Die Baugruppe 1 wird dabei in Berührung mit einer entsprechenden Anschlagsfläche des Gehäuses 2 gebracht. Der Steckverbinder befindet sich dann auf dem Niveau der Öffnung 21 des Gehäuses 2 und ist in Richtung der Öffnung 21 ausgerichtet.

Im Basisteil 11 sind Kontaktstifte 113 eingedrückt. Die Kontaktstifte 113 sind auf einer Seite mit den Stanzgittern 112 kontaktiert. Auf der anderen Seite ist eine flexible Leiterbahnfolie (Flexfolie) an die Stifte gelötet. Die flexible Leiterbahnfolie 13 stellt eine elektrische Verbindung zwischen den Stanzgittern 112 und Steckerstiften 121 her, die in den Steckverbinder 12 eingedrückt sind. In der Montageposition weist die flexible Leiterbahnfolie 13 eine Schleife auf, die genügend Spiel bereitstellt, so daß der Steckverbinder 12 aus seiner Montageposition in eine Endposition bewegt werden kann.

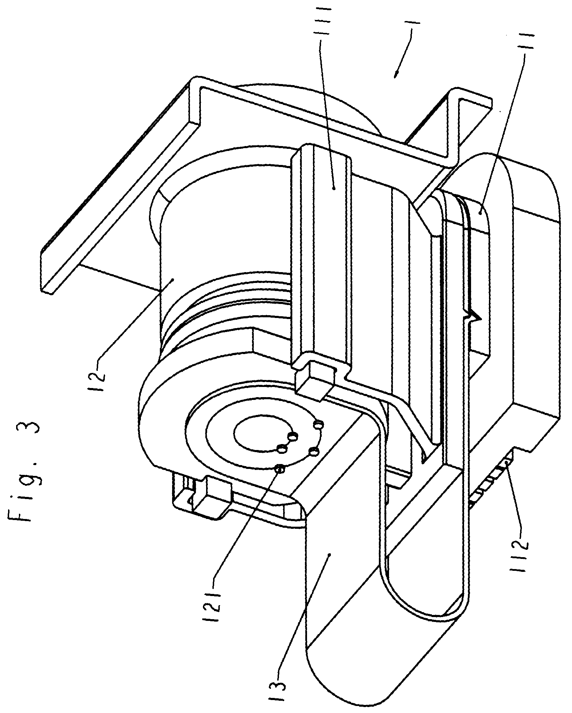

In Figur 3 ist erkennbar, daß im Basisteil 11 eine schleifenartige, V-förmige Zugentlastung für die flexible Leiterbahnfolie 13 ausgebildet ist. Die Leiterbahnfolie 13 wird in der Zugentlastung durch einen von der Führung 111 vorspringenden Keil eingeklemmt.

Der aus Kunststoff bestehende Steckverbinder 12 weist seitliche Schienen auf, die in Nuten der Führung 111 verlaufen. Der Steckverbinder ist durch die Öffnung des Gehäuses durchgeführt. Vom Gehäuse ist nur ein schmaler Abschnitt dargestellt.

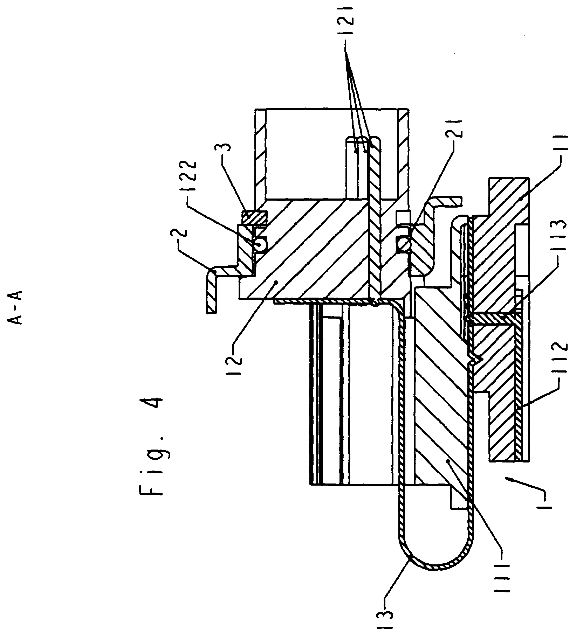

Figur 4 veranschaulicht die Endposition des Steckverbinders 12 nach der Montage.

Nachdem ein Greifwerkzeug eines Automaten durch die Öffnung 21 des Gehäuses 2 hindurchgeführt worden und in Eingriff mit dem Inneren des Steckverbinder gebracht worden war, wurde der Steckverbinder in der horizontalen Ebene, also senkrecht zur Einbaurichtung der Baugruppe, nach außen gezogen und in Berührung mit Anschlagsflächen des Gehäuses 2 gebracht. Der Steckverbinder 12 befindet sich daher spätestens im eingebauten Zustand quer zur Einbaurichtung der Baugruppe 1.

Das Greifwerkzeug kann entweder einen Reibschluß, beispielsweise mit einem pneumatisch oder hydraulisch betätigbaren Stempel, oder einen Formschluß mit dem Steckverbinder 12 herstellen, beispielsweise über einen Hinterschnitt im Inneren des Steckverbinders oder einem Durchbruch. Ferner können die Steckerstifte 121 Einschnürungen zum Ansetzen des Greifers aufweisen.

Ein als Klammer ausgebildetes Fixierelement 3 ist außerhalb des Gehäuses auf den Steckverbinder 12 aufgesteckt und hält ihn zuverlässig in seiner Endposition. Als Dichtelement zwischen den Steckverbinder 12 und dem Gehäuse 2, und genauer der Gehäuseöffnung 21, sorgt ein O-Ring für Dichtigkeit. Das Fixierelement ist senkrecht zur Achse des Steckverbinders 12 gesteckt.

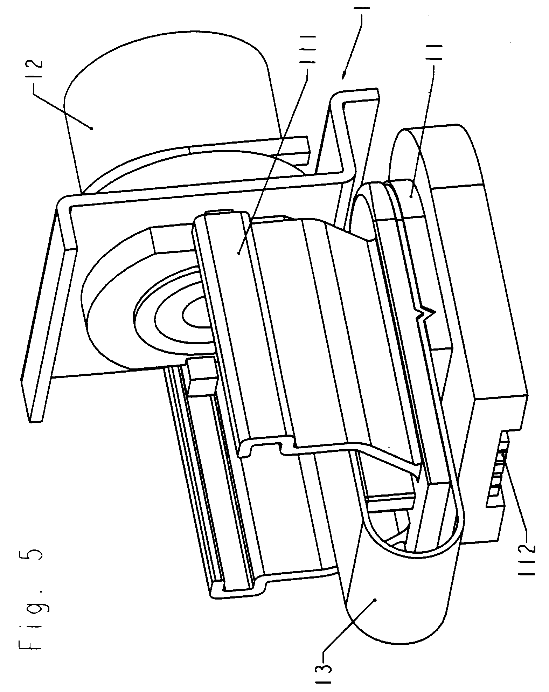

In Figur 5 ist der Steckverbinder bis zum Anschlag durch eine Abdeckung der Baugruppe 1 hindurchgefahren, die zur Anlage am Gehäuse 2 bestimmt ist.

## Patentansprüche

1. Baugruppe (1) zum Einbau in ein Gehäuse (2) mit einem Steckverbinder (12), der quer zur Einbaurichtung der Baugruppe (1) angeordnet ist und im eingebauten Zustand durch eine Öffnung des Gehäuses (2) ragt, die aufweist:
- ein Basisteil (11),
- eine auf dem Basisteil (11) angeordnete Führung (111) für den Steckverbinder (12), die eine Montageposition für den Steckverbinder (12) aufweist, aus der der Steckverbinder (12) in eine Endposition verschiebbar ist,
- eine flexible elektrische Verbindung zwischen dem Steckverbinder (12) und dem Basisteil (11).

2. Baugruppe nach dem vorhergehenden Anspruch, dadurch gekennzeichnet, daß der Steckverbinder (12) mit einer flexiblen Leiterbahnfolie (13) elektrisch mit dem Basisteil (11) verbunden ist.

3. Baugruppe nach dem vorhergehenden Anspruch, dadurch gekennzeichnet, daß die flexible Leiterbahnfolie (13) zwischen dem Basisteil (11) und der Führung (111) eine Zugentlastung ausbildet.

4. Baugruppe nach einem der vorhergehenden Ansprüche, dadurch gekennzeichnet, daß die Baugruppe (1) ein Steuergerät zum Steuern eines Getriebes aufweist.

5. System aus einer Baugruppe (1) nach einem der vorhergehen den Ansprüche und einem Gehäuse (2), bei dem der Steckverbinder (12) von der Innenseite des Gehäuses (2) durch eine Öffnung (21) des Gehäuses nach außen ragt.

6. System nach dem vorhergehenden Anspruch, dadurch gekennzeichnet, daß das Gehäuse (2) ein Getriebegehäuse eines Kraftfahrzeugs ist.

7. Verfahren zum Einbau einer Baugruppe (1) mit einem Steckverbinder (12), der quer zur Einbaurichtung anzuordnen ist, in ein Gehäuse (2), mit den Schritten:
- die Baugruppe (1) wird im Gehäuse (2) befestigt,
- ein Greifwerkzeug eines Automaten wird durch eine Öffnung (21) des Gehäuses (2) geführt, das Greifwerkzeug ergreift den Steckverbinder (12) und zieht ihn in die Öffnung (21).

8. Verfahren nach dem vorhergehenden Anspruch, dadurch gekennzeichnet, daß der Steckverbinder (12) in einer Führung (111) quer zur Einbaurichtung und in Richtung der Öffnung (21) vom Greifwerkzeug gezogen wird.
